# EUROPEAN PATENT SPECIFICATION

(11) **EP 0 608 442 B1**
(45) Date of publication and mention of the grant of the patent: **05.08.1998**
(21) Application number: 92830692.7
(22) Date of filing: 30.12.1992
(51) Int. Cl.: G01R 31/06

(54) **Rotor winding short circuit detector**
Rotorwindungsschlussdetektor
Détecteur de court-circuits pour enroulements des rotors

(43) Date of publication of application: 03.08.1994
(73) Proprietor: ANSALDO ENERGIA S.P.A., I-16152 Genova (IT)
(72) Inventor: Barbero, Vittorio, I-16122 Genova (IT); Cimbrico, Pierluigi, I-16136 Genova (IT); Grigoli, Giorgio, int.5 I-16152 Genova (IT); Lanteri, Carlo, I-18020 Cosio d'Arroscia-Imperia (IT); Puzone, Roberto, I-16136 Genova (IT)
(74) Representative: Siniscalco, Fabio

(56) References cited:
- EP-A- 0 377 854
- EP-A- 0 391 181
- US-A- 4 377 784
- IEEE TRANSACTIONS ON POWER APPARATUS AND SYSTEMS vol. PAS90, no. 2, April 1971, NEW YORK US pages 478 - 483 ALBRIGHT 'INTERTURN SHORT-CIRCUIT DETECTOR...'

## Description

The subject of the present invention is apparatus for detecting short circuits between the turns of the field winding of the rotor of a smooth-rotor alternator, that is one having a rotor with non-salient poles, and in particular a turboalternator.

As is known, a turboalternator is a synchronous generator of sinusoidal alternating current constructed for coupling directly to the shaft of a gas or steam turbine.

A turboalternator includes a field circuit disposed on the rotor and an armature circuit disposed on the stator. The field circuit is constituted by a winding arranged in a series of suitable slots formed in the body of the rotor. Each slot houses several superposed turns of the winding. A turboalternator normally has two or four poles which are magnetised by the field winding suitably wound in the slots.

The individual turns in each slot are insulated from each other by a suitable insulating material, for example glass-reinforced resin. In time, because of pollution, abrasion and thermal and mechanical stresses, the original insulating properties of the insulating material may fall considerably until short circuits are created between the turns of the field winding.

These short circuits obviously reduce the performance of the turboalternator and it is therefore important to enable their presence to be detected in order for suitable repairs to be made to the rotor.

It is already known to detect the presence of such short circuits by means of an analysis of the variations in the magnetic flux distribution in the air gap between the stator and the rotor. In practice, a detection winding is used which is located close to the rotor and is passed in sequence by the slots of the rotor. The detection winding detects a signal constituted by a series of pulses; each pulse corresponds to the variation in the flux distribution from a particular slot as it passes the winding itself. The amplitude of each pulse is proportional to the magnetomotive force generated by the winding in the slot and, hence, also to the number of turns in each slot. If there are short-circuited turns in a slot, the corresponding pulse is reduced in amplitude to an extent directly proportional to the number of turns short circuited.

The actual detection of the short-circuiting is effected by feeding the series of pulses generated by the detection winding to an oscilloscope which is read appropriately by an operator.

It is, however, necessary for the operator to be specialised in order to be able to interpret the signals correctly and detect the short circuits and this is a primary problem.

Furthermore, the operator, although specialised, may judge erroneously that a reduction in the amplitude of a pulse which is caused simply by a disturbance is due to a short circuit in a slot and this is a further disadvantage.

Finally the presence and the very assiduous attention of an operator is required and this is yet a further disadvantage.

US-A-4,377,784 and EP-A-0,391,181 disclose apparata of the type specified, based on the emission of pulse trains to be processed by an electronic unit.

The object of the present invention is to provide apparatus which is able to indicate, without the need for an operator and without error:
- the existence of short circuits between the turns of the field winding of the rotor of a turboalternator in one or more slots of the rotor;
- the precise location of the slot or slots in which short-circuiting has occurred;
- the magnitude of the short-circuiting.

This object is achieved by means of apparatus for detecting short circuits between the turns of the field winding of the rotor of a smooth-rotor alternator based on an analysis of the variations in the magnetic flux distribution in the air gap between the stator and the rotor of the alternator, the apparatus being defined by the appended main claim.

In order to provide a better understanding of the characteristics and advantages of the present invention, a description of two embodiments is given below by way of non-limiting example and illustrated in the appended drawings in which:
Figure 1 is a schematic view of first apparatus according to the invention for detecting short circuits in the rotor of a turboalternator;
Figure 2 is a schematic view of second apparatus according to the invention for detecting short circuits in the rotor of a turboalternator;
Figure 3 is an enlargement of a chart illustrated in Figures 1 and 2;
Figure 4 shows a turboalternator to which one or other of the apparata of Figures 1 and 2 may be applied and also shows a turbine coupled to the turboalternator;
Figure 5 is a partial, cross-sectional, schematic view of the turboalternator of Figure 4 on which a support structure for a detection winding forming part of the apparata of Figures 1 and 2 is mounted;
Figure 6 shows an enlarged detail of Figure 5 in which the detection winding is illustrated.

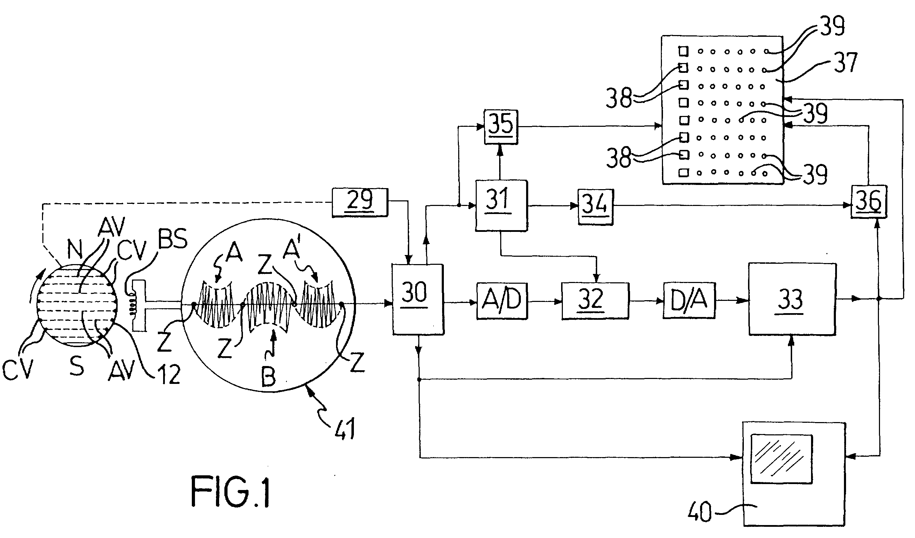

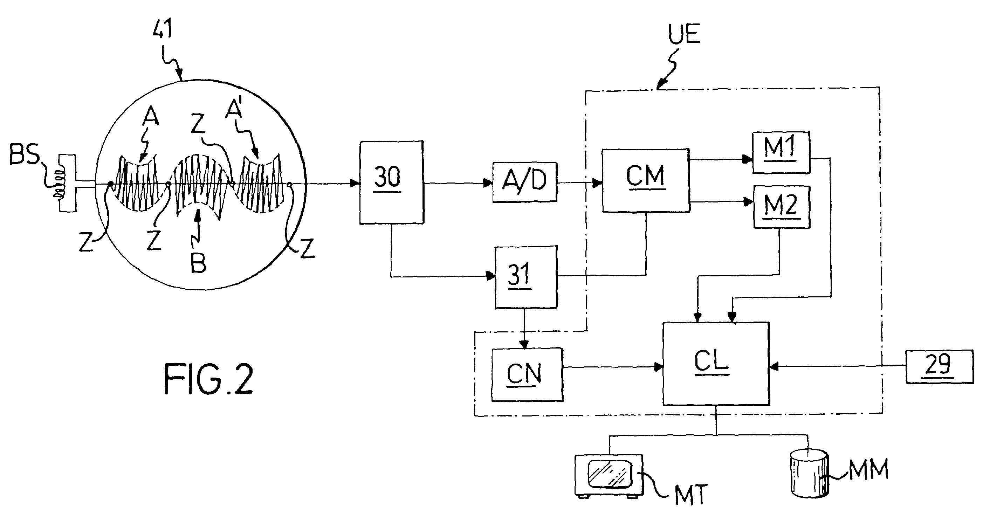

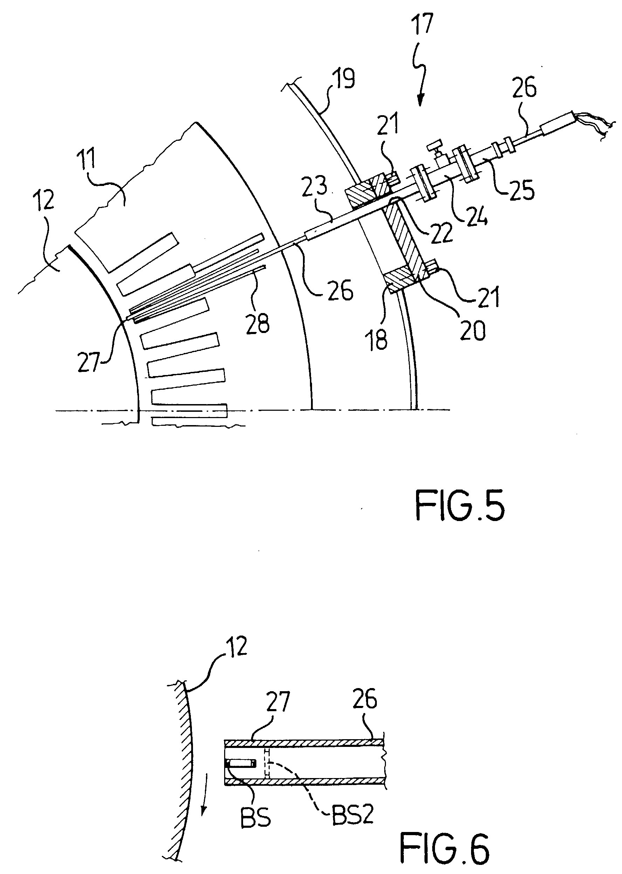

Before the apparata of Figures 1 and 2 are described, the turboalternator to which the said apparata may be applied will be described below with reference to Figures 4 and 5.

This turboalternator generally indicated 10 comprises a stator 11 and a smooth rotor 12.

The field circuit, disposed on the rotor 12, is formed by a winding arranged in a series of suitable slots formed in the body of the rotor 12. Each slot houses several superposed turns of the winding. The rotor 12 of the turboalternator 10 has two poles which are magnetised by the field winding suitably wound in the slots.

The turboalternator 10 is coupled to a turbine 13 through a shaft 14 which connects the axle of the rotor 12 to the axle of the turbine 13. A commutator 15, connected through a shaft 16 to the axle of the rotor 12, is provided to supply the field winding of the rotor 12 with suitable energisation current.

The apparata shown in Figures 1 and 2 are adapted to detect short circuits between the turns of the field winding of the rotor 12 on the basis of an analysis of the variations in the magnetic flux distribution in the air gap between the stator 11 and the rotor 12, picked up by a detection winding disposed close to the rotor 12.

For this purpose, the said apparata have a mechanical part which enable the detection winding to be placed in immediate proximity to the rotor 12.

With reference to Figures 5 and 6, this mechanical part provides a support structure 17 including an annular plate 18 fitted into an aperture formed in the outer casing 19 of the turboalternator 10 and fixed to the walls of the casing itself. To the outer face of the annular plate 18 is fixed a solid plate 20 by means of an annular series of bolts 21; a sealing gasket is interposed between the plates 18 and 20. The solid plate 20 is formed with an eccentric hole 22 into which is fixed a tube 23 which puts the exterior and the interior of the turboalternator 10 into communication through the hole 22 and the circular aperture in the annular plate 18. To the outer end of the tube 23 is fixed a ball valve 24. To the valve 24 is fixed a tube 25 containing a sealing washer. A tube 26 is also provided which has an outer diameter less than the inner diameter of the tube 23, the valve 24 and the tube 25. A detection winding, visible in Figure 6 and indicated BS, is fixed to one end 27 of the tube 26.

The tube 26 is inserted through the tube 25, the valve 24, the tube 23 and through a ventilation duct 28 in the stator 11 until its end 27 is close to the rotor 12.

The apparata shown in Figures 1 and 2 then have an electronic part to which the signal detected by the detection winding BS is fed.

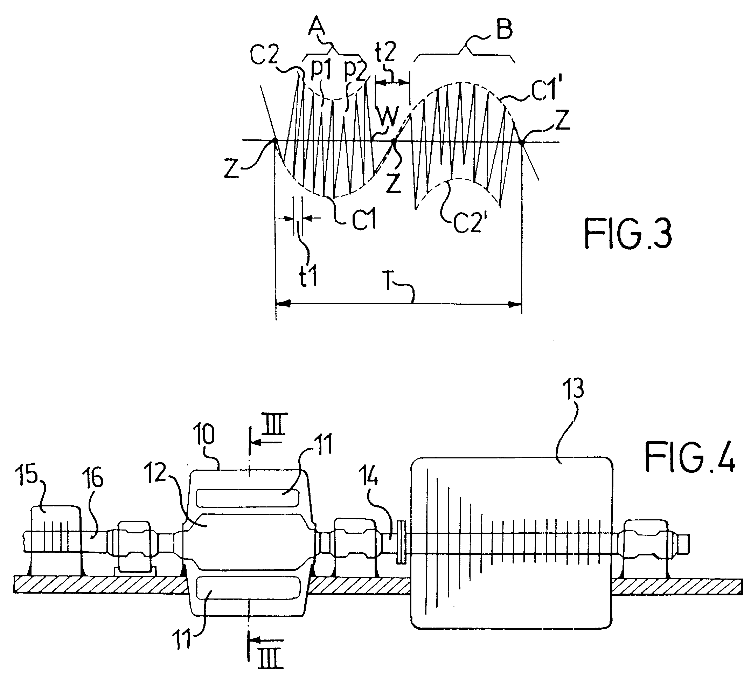

The signal detected by the winding BS is illustrated in detail in Figure 3. The wave form of the signal of Figure 3 refers to the case in which the turboalternator 10 functions with the terminals of the stator 11 short circuited. In general it is a series of pulse trains. If the two poles of the rotor are indicated conventionally as N and S respectively, starting with the North pole in correspondence with the winding BS, a first pulse train A is caused by the variations in the magnetic flux distribution in the air gap between the stator 11 and the rotor 12 which are detected by the winding BS as it is passed by the slots in sequence and which change from North pole to South pole. The second pulse train B is caused by the variations in the magnetic flux distribution in the air gap detected by the winding BS as it is passed by the slots in sequence and which change from South pole to North pole. The next pulse train (not illustrated in Figure 3) will again be due to the situation envisaged for the first pulse train A. The peaks in the said pulse trains, in general, touch two pairs of envelope curves C1, C2 and C1', C2' respectively when there are no short circuited turns.

Figure 3 indicates several additional parameters and, more particularly, the period of the voltage generated by the turboalternator 10 corresponding to one revolution of the rotor 12 is indicated T while the time interval for the passage from one slot to an adjacent slot is indicated t1, the time interval for the passage of the pole is indicated t2 and W indicates the point at which the signal passes through zero on passage from one slot to another, while Z indicates the point at which the signal passes through zero on passage of the pole.

It should also be noted that as T varies, the ratios t1/t2, t1/T, t2/T remain the same, these being linked to the geometry of the turboalternator 10; hence it is always possible to recognise and to distinguish the points W from the points Z.

The pulses P1 and P2 have a smaller amplitude than the other pulses since they relate, by way of example, to slots in which there is a short circuit between the turns of the winding, a short circuit which causes a proportional reduction in the magnetic flux distribution in the air gap between the stator 11 and the rotor 12.

The apparatus of Figure 1 will now be described.

In Figure 1, the rotor 12 of the turboalternator 10 is illustrated schematically: the field winding of the rotor 12 is indicated AV and the slots which house the field winding are indicated CV. The winding BS is disposed close to the rotor 12 by means of that part of the apparatus constituted by the structure shown in Figure 5.

The apparatus also has a sensor for sensing an angular reference position of the rotor 12, indicated by a block 29, which may be an opto-electronic device combined with an indicator element provided on the shaft of the rotor 12 in a suitable angular position. As the indicator element passes the opto-electronic device, the latter outputs an electrical signal which enables a specific angular position of the rotor 12 to be identified. It is convenient for the indicator element to be provided on the shaft of the rotor 12 so as to make the optoelectronic device output the signal when one of the two poles, North and South, of the rotor, for example the North pole, passes the detection winding BS.

The electronic part of the apparatus of Figure 1, to which the signal picked up by the winding BS is fed, includes:
- a signal conditioner 30;
- a synchroniser 31;
- an analog/digital converter A/D;
- a digital delay 32;
- a digital/analog converter D/A;
- a comparison and measurement circuit 33;
- a period counter 34;
- a slot counter 35;
- an anomaly counter 36.

There is also a screen 37 on which there is a set of indicators lamps 38 of a first type disposed vertically and several sets of indicator lamps 39 of a second type disposed horizontally, each set of indicator lamps 39 being aligned with a respective one of the indicator lamps 38.

The apparatus is finally completed by an oscilloscope 40.

The apparatus of Figure 1 functions in the manner described below.

The signal picked up by the winding BS, shown in a circle 41 (which also illustrates the pulse train A', not illustrated in Figure 3, after the pulse train B) is fed to the signal conditioner 30.

The signal conditioner 30 filters the input signal to remove spurious signals and standardises the amplitude so as to make it as compatible as possible with the synchroniser 31 and the analog/digital converter A/D.

The signal output by the signal conditioner 30 is fed: to the oscilloscope 40, to the synchroniser 31, to the analog/digital converter A/D, to the slot counter 35, and to the comparison and measurement circuit 33.

The synchroniser 31 identifies a reference point in the signal generated by the winding BS, for example the passage through the point Z and thus synchronises the delay 32, the period counter 34 and the slot counter 35.

The analog/digital converter A/D converts the signal from the signal conditioner 30 from analog to digital and feeds it to the delay 32.

The delay 32 delays the input signal by T/2 and feeds it to the digital/analog converter D/A which converts it from digital to analog.

From the converter D/A the signal is fed to the comparison and measurement circuit 33 which thus receives at its input both the signal actually generated by the winding BS and the same signal with its phase changed by T/2; this enables the comparison circuit 33, after inversion of the polarity of the signal whose phase is changed by T/2, to compare the pulse train of type A with the pulse train of type B and to ascertain whether there is any difference between the amplitude of each pulse in the pulse train of type A and the amplitude of the corresponding pulse in the pulse train of type B and, where there is a difference, to measure its magnitude. The signal output by the comparison and measurement circuit 33 is fed to the counter 36, to the screen 37 and to the oscilloscope 40. If the circuit 33 does not find any difference between the pulse trains it outputs a nil signal; in the opposite case, if there is a difference between two pulses relating to corresponding slots, it outputs a signal having a value corresponding to this difference and indicates an anomaly.

The counter 36, for each slot CV, counts the number of anomalies which are found over a length of time referred to the slot itself and is zeroed after a certain number of periods T by the counter 34 which counts the periods T. If the number of anomalies in this particular number of periods T is greater than a predetermined number, the counter 36 switches on the indicator lamps 39 of the screen 37 as will be seen below while, in the contrary case, it keeps them switched off.

The slot counter 35, which identifies numerically the slots CV which pass the winding BS on the basis of the passage of the signal from the winding BS through the points W, lights the indicator lamps 38 in sequence as the slots CV pass the winding BS such that each lamp corresponds to a respective slot CV ; the lighting of an indicator lamp 38 thus corresponds to the passage of a respective slot CV past the winding BS. Simultaneously the signal from the comparison and measurement circuit 33, on enabling by the counter 36, switches on a certain number of indicator lamps 39 aligned with the indicator lamp 38 of the slot CV which has an anomaly. The number of indicator lamps 39 activated corresponds to the magnitude of the anomaly.

One should say that, if a slot is found to have an anomaly a specific number of times in a certain number of periods, it is certainly a short circuit and is indicated clearly on the screen 37 where both the slot in which the short circuit has occurred and the magnitude of the short circuit can be read.

If the anomaly has been found for a smaller number of times than the said specific number of times, then it may be a disturbance and is not indicated on the screen 37.

The oscilloscope 40 displays both the signal generated by the winding BS and the difference signal generated by the comparison and measurement circuit 33 so that both can be seen simultaneously and in such a manner that the difference signal is in correspondence with the reduced amplitude pulse.

The sensor 29 enables the signal conditioner 30 to initiate the treatment of the signal from the winding BS only at the moment at which the North pole of the rotor 12 passes the winding BS so as to give an initial reference which enables the slot in which the short circuit has occurred to be identified unequivocally.

The apparatus of Figure 2 differs from the apparatus of Figure 1 in that it uses an electronic microprocessor unit UE. In Figure 2 the blocks within the broken line which identifies the processing unit UE relate to sections of this processing unit.

In the apparatus of Figure 2, the signal generated by the winding BS is again sent to a signal conditioner 30 and from here to an analog/digital converter A/D and to a synchroniser 31 as seen in the apparatus of Figure 1. The signal output by the converter A/D and by the synchroniser 31 is, however, sent to the processing unit UE.

The signal from the converter A/D and from the synchroniser 31 is processed by the software of the processing unit UE such that it acts as a switch CM and sends the pulse train of type A to a memory M1 and the pulse train of type B to a memory M2.

The signal from the synchroniser 31 is also processed by the software of the processing unit UE such that it acts as a counter, shown schematically in a block CN, for counting the periods T and the number of slots CV, in a similar manner to that envisaged for the counters 34 and 35 of the apparatus of Figure 1.

At this point, a calculating section CL of the processing unit UE, on the basis of the signals present in the memories M1, M2, the signals coming from the counter CM, and the signal of the angular reference position of the rotor coming from a sensor 29 identical to that already seen in the apparatus of Figure 1, is able to compare and measure the amplitudes of the pulses of the pulse train of type A with the amplitudes of the pulses of the pulse train of type B and to detect any differences and verify the existence and location of any short circuits and evaluate their magnitudes.

This data may then be displayed visually in a suitable manner on a monitor MT so as to give a precise indication of the slot or slots in which the short-circuiting has occurred and the magnitude of the short-circuiting, in a manner similar to that in the apparatus of Figure 1 on the visual display unit 37.

In order to eliminate the disturbance signals, the calculating section CL may, for example, make an average of the differences detected for each pair of corresponding pulses over a period of time: if this average tends to zero, this indicates that the differences detected are due to disturbance signals because of their random nature; if the average keeps almost constant, however, the differences detected are indeed due to a short circuit in the slot corresponding to the pulse which is of smaller amplitude than normal.

The data present in the memories M1 and M2 and the data processed in the section CL may also be sent to a mass memory MM from which all the data may be recovered at any time so that it is disconnected in time from the operation of the turboalternator 10.

From what has been described above and illustrated in the drawings, it will be well understood that both the apparatus of Figure 1 and the apparatus of Figure 2 are able to indicate, without intervention by an operator and without error:
- the existence of short circuits between the turns of the rotor winding in one or more slots CV of the rotor 12 of the turboalternator 10;
- the precise location of the slot or slots CV in which short-circuiting has occurred;
- the magnitude of the short-circuiting.

The apparatus of Figure 2 has the further advantage over the apparatus of Figure 1 of displaying and treating the signal from the winding BS at a time which is different from the moment at which the signal is generated thanks to the memories M1, M2 and the mass memory MM, while the apparatus of Figure 1 is constrained to operate in real time, that is, is constrained to operate at the moment at which the said signal is generated.

When the turboalternator 10 is operated under load or without load, the wave form of the signal detected by the winding BS is not as intelligible, nor hence as easily processable, as the signal of Figure 3. In these cases the apparatus of Figure 2, thanks to the electronic microprocessor unit UE overcomes the difficulties linked to the lesser intelligibility. In such cases, with the apparatus of Figure 1, it is necessary for the signal conditioner, in addition to treating the signal as indicated above, to render the signal more processable by the circuits downstream thereof as well.

With regard to the mechanical part of the apparatus, illustrated in Figure 5, it should be noted that this enables the tube 23 to be brought precisely into alignment with the ventilation duct 28. In fact, to achieve this alignment, before the bolting of the plate 20 and insertion of the tube 26 into the tube 23, the plate 20, with the tube 23 inserted, is rotated relative to the annular plate 18 until the tube 23 has reached an angular position relative to the plate 18 such that the tube 23 is aligned with the ventilation duct 28. The bolts 21 are then tightened and the tube 26 inserted. The gasket between the plates 18 and 20 and the seal in the duct 25 form a seal to prevent any pressurised hydrogen in the interior of the turboalternator 10 from escaping, with a resulting cooling action. When the tube 26 is removed, hydrogen is prevented from escaping by closure of the valve 24.

The apparatus indicated above may be applied to any smooth-rotor alternator and not necessarily to a turboalternator. With obvious modifications, the apparatus may also be applied to an alternator with more than two poles, for example a four-pole alternator.

Both the mechanical structures and the circuit and logic structures may be replaced by functionally equivalent structures.

In addition to the winding BS which is located so as to pick up the magnetic flux distribution tangentially of the rotor 12, a further winding may be provided, illustrated in broken outline in Figure 6 and indicated BS2, located so as to pick up the radial magnetic flux distribution. Several detection windings BS may also be provided as well as possibly several additional detection windings BS2.

## Claims

1. Apparatus for detecting short circuits between the turns of the field winding (AV) of the rotor (12) of a smooth-rotor alternator (10) based on an analysis of the variations of magnetic flux distribution in the air gap between the stator (11) and the rotor (12) of the alternator (10), the apparatus including:
- at least one detection winding (BS) sensitive to variations in the magnetic flux distribution and located close to the rotor (12) and passed in sequence by slots (CV) housing the field winding during rotation of the rotor (12);
- sensor means (29) for sensing an angular reference position of the rotor (12);
- a microprocessor electronic processing unit (UE), which receives a series of pulse trains (A, B) detected by said at least one detection winding (BS) in dependence on the variations of magnetic flux distribution, each pulse train (A, B) being originated by the passage, past said at least one detection winding (BS), of slots (CV) presenting themselves in sequence from one pole to the next one of the rotor (12), the pulse train (A) relating to a series of slots (CV) being fed by means of a switch (CM) to a first of its memories (M1) and the pulse train (B) relating to a series of slots corresponding to the preceding series to a second of its memories (M2), the processing unit (UE) comprising a calculating section (CL) which compares the pulse trains present in the memories (M1, M2), measures the differences between the corresponding pulses of the pulse trains (A, B), forms an average of said differences over the time, checks if said average keeps almost constant, in such a case said differences being due to a short circuit, locates said short circuit on the basis of an angular position datum provided by said sensor means for sensing an angular reference position and on the basis of a count of the voltage periods of the alternator (10) or of the revolutions of the rotor(12) which count is based on the passages through zero of the signal detected by the detection winding (BS) on passage of the pole, and of the slot (CV) count based on the passages through zero of the signal detected by the detection winding (BS) on passage from one slot to another;
- a synchroniser (31), for identifying a reference point in the signal generated by the detection winding (BS), intended to synchronise said processing unit (UE);
- indicator means (MT) for indicating the processed data from said calculating section (CL).

2. Apparatus according to claim 1, wherein the detection winding (BS) is located close to the rotor (12) by means of a first tube (26) to one end of which is fixed the detection winding (BS) and which extends from the exterior to the interior of the alternator (10) and which is sealingly inserted in a second tube (23) mounted on support members (18, 20) fixed to the alternator to bring said end, and hence the detection winding (BS), into close proximity with the rotor (12), the support elements (18, 20) being adjustable in position to bring the second tube (23) into alignement with the ventilation duct (28).

3. Apparatus according to claim 2, wherein the support elements include an annular plate (18) fixed to the casing (19) of the alternator (10) and a solid plate (20) fixed and sealed to the annular plate (18) and having an eccentric hole (22) in which the second tube (23) is inserted, the position of fixing of the solid plate (20) relative to the annular plate (18) being angularly adjustable.

4. Apparatus according to claim 2, wherein a valve (24) is provided for closing an outer end of the second tube (23) when the first tube (26) is removed from the second tube (23).

## Patentansprüche

1. Vorrichtung zum Detektieren von Kurzschlüssen zwischen den Windungen einer Feldwicklung (AV) des Rotors (12) eines Glattanker-Wechselstromgenerators (10) durch Analysieren der Veränderungen in der Magnetflußverteilung im Luftspalt zwischen dem Ständer (11) und dem Rotor (12) des Wechselstromgenerators (10), umfassend
- wenigstens eine auf Veränderungen in der Magnetflußverteilung reagierende Detektierwicklung (BS), die in der Nähe des Rotors (12) angeordnet ist und an der während der Drehung des Rotors (12) die Feldwicklung aufnehmende Schlitze (CV) nacheinander vorbeigeführt werden;
- Sensoren (29) zum Erfassen einer Winkelreferenzstellung des Rotors (12);
- eine elektronische Mikroprozessor-Verarbeitungseinheit (UE), die eine von der wenigstens einen Detektierwicklung (BS) in Abhängigkeit der Veränderungen in der Magnetflußverteilung detektierte Reihe von Pulsfolgen (A, B) empfängt, wobei jede Pulsfolge (A, B) durch das Vorbeiführen der Schlitze (CV) an der wenigstens einen Detektierwicklung (BS) entsteht, wobei die Schlitze (CV) von einem Pol zum anderen des Rotors (12) nacheinander angeordnet sind und die Pulsfolge (A) einer Reihe von Schlitzen (CV) mittels eines Schalters (CM) einem ersten Speicher (M1) zugeführt wird, und die Pulsfolge (B) einer der vorangegangen Reihe entsprechenden Reihe von Schlitzen einem zweiten Speicher (M2) zugeführt wird, wobei die Verarbeitungseinheit (UE) eine Recheneinheit (CL) aufweist, die die in den Speichem (M1, M2) vorhandenen Pulsfolgen vergleicht, die Differenzen zwischen den entsprechenden Pulsen der Pulsfolgen (A, B) erfaßt, einen Durchschnittswert aus den Differenzen bezogen auf die Zeit bildet und prüft, ob der Durchschnittswert dabei vorwiegend konstant bleibt, wobei sich in diesem Fall die Differenzen aus einem Kurzschluß ergeben, den Kurzschluß aufgrund der von den Sensoren zum Erfassen einer Winkelreferenzstellung gelieferten Winkelstellungsdaten sowie aufgrund der Anzahl der Spannungsperioden des Wechselstromgenerators (10) oder der Umdrehungen des Rotors (12), wobei die Anzahl abhängig ist vom Durchlaufen des von der Detektierwicklung (BS) detektierten Signals durch Null bei Vorbeiführen des Pols, und aufgrund der Anzahl der Schlitze (CV) in Abhängigkeit des Durchlaufens des von der Detektierwicklung (BS) detektierten Signals durch Null beim Vorbeiführen von einem Schlitz zum anderen, lokalisiert;
- eine Synchronisiereinrichtung (31) zum Identifizieren eines Referenzpunktes in dem von der Detektierwicklung (BS) erzeugten Signal zur Synchronisation der Verarbeitungseinheit (UE);
- Anzeigevorrichtungen (MT) zum Anzeigen der verarbeiteten Daten von der Recheneinheit (CL).

2. Vorrichtung nach Anspruch 1, bei der die Detektierwicklung (BS) mittels eines ersten Rohres (26) in der Nähe des Rotors (12) angeordnet ist, wobei die Detektierwicklung (BS) an dem einen Ende des Rohres (26) angebracht ist, das von außen in das Innere des Wechselstromgenerators (10) verläuft und das abgeschlossen in einem auf am Wechselstromgenerator befestigten Trägern (18, 20) angebrachten zweiten Rohr (23) angeordnet ist, zum Anbringen des Endes und somit der Detektierwicklung (BS) in der Nähe des Rotors (12), wobei die Träger (18, 20) zur axialen Ausrichtung des zweiten Rohres (23) mit dem Luftkanal (28) unterschiedlich positionierbar sind.

3. Vorrichtung nach Anspruch 2, wobei die Träger eine am Gehäuse (19) des Wechselstromgenerators (10) befestigte ringförmige Platte (18) und eine an der ringförmigen Platte (18) befestigte und abgedichtete feste Platte (20) aufweisen, mit einem exzentrischen Loch (22), in welches das zweite Rohr (23) eingebracht ist, wobei die Lage beim Befestigen der festen Platte (20) an der ringförmigen Platte (18) winkelverstellbar ist.

4. Vorrichtung nach Anspruch 2, in der ein Ventil (24) zum Verschließen eines äußeren Endes des zweiten Rohres (23) bei Entfernung des ersten Rohres (26) aus dem zweiten Rohr (23) vorgesehen ist.

## Revendications

1. Appareil destiné à détecter des court-circuits entre les spires du bobinage de champ (AV) du rotor (12) d'un alternateur (10) à rotor lisse basé sur l'analyse des variations de la distribution de flux magnétique dans l'écartement d'air entre le stator (11) et le rotor (12) de l'alternateur (10), l'appareil comprenant :
- au moins un bobinage de détection (BS) sensible aux variations de la distribution de flux magnétique et situé près du rotor (12) et que traversent en succession des fentes (CV) logeant le bobinage de champ pendant la rotation du rotor (12) ;
- un moyen (29) de détection destiné détecter une position de référence angulaire du rotor (12) ;
- une unité de traitement de données à microprocesseur (UE), qui reçoit une série de trains d'impulsions (A, B) détectés par ledit au moins un bobinage de détection (BS) en fonction des variations de la distribution de flux magnétique, chaque train d'impulsion (A, B) étant généré par le passage, devant ledit au moins un bobinage de détection (BS), des fentes (CV) se présentant elles-mêmes en succession d'un pôle au pôle suivant du rotor (12), le train d'impulsions (A) étant associé à une série de fentes (CV) qui est amenée au moyen d'un interrupteur (CM) à une première (M1) de ses mémoires et le train d'impulsions (B) étant associé à une série de fentes correspondant à la série précédente à une seconde (M2) de ses mémoires, l'unité (UE) de traitement de données comprenant une section de calcul (CL) qui compare les trains d'impulsions présents dans les mémoires (M1, M2), mesure les différences entre les impulsions correspondantes des trains d'impulsions (A, B), forme une moyenne desdites différences dans le temps, vérifie si ladite moyenne reste presque constante, dans un tel cas où lesdites différences qui sont dues à un court-circuit, localise ledit court-circuit sur la base d'une donnée de position angulaire fournie par ledit moyen de détection pour détecter une position de référence angulaire et sur la base d'un comptage des périodes de tension de l'alternateur (10) ou des tours du rotor (12), lequel comptage est basé sur les passages par zéro du signal détecté par le bobinage de détection (BS) lors du passage du pôle, et du comptage de fentes (CV) basé sur les passages par zéro du signal détecté par le bobinage de détection (BS) lors du passage d'une fente à l'autre ;
- un synchronisateur (31), pour identifier un point de référence dans le signal produit par le bobinage de détection (BS), destiné synchroniser ladite unité (UE) de traitement de données ;
- un moyen d'indication (MT) destiné à indiquer les données traitées par la section de calcul (CL).

2. Appareil selon la revendication 1, dans lequel le bobinage de détection (BS) est situé près du rotor (12) au moyen d'un premier tube (26) à une extrémité duquel est fixé le bobinage de détection (BS) et qui s'étend de l'extérieur à l'intérieur de l'alternateur (10) et qui est inséré de façon étanche dans un second tube (23) monté sur des éléments de support (18, 20) fixés à l'alternateur pour amener ladite extrémité, et donc le bobinage de détection (BS), dans un voisinage très proche du rotor (12), les éléments de support (18, 20) étant réglables en position de façon à amener le second tube (23) en alignement avec le conduit de ventilation (28).

3. Appareil selon la revendication 2, dans lequel les éléments de support comprennent une plaque annulaire (18) fixée au boîtier (19) de l'alternateur (10) et une plaque pleine (20) fixée et scellée à la plaque annulaire (18) et comportant un trou excentrique (22) dans lequel le second tube (23) est inséré, la position de fixation de la plaque pleine (20) par rapport à la plaque annulaire (18) étant réglable angulairement.

4. Appareil selon la revendication 2, dans lequel une valve (24) est prévue pour fermer une extrémité extérieure du second tube (23) lorsque le premier tube (26) est enlevé du second tube (23).
